# EUROPÄISCHE PATENTANMELDUNG

(11) **EP 1 770 864 A1**
(43) Veröffentlichungstag der Anmeldung: **04.04.2007**
(21) Anmeldenummer: 05021560.7
(22) Anmeldetag: 01.10.2005
(51) Int. Cl.: H03K 17/97

(54) **Dreh-Zugschalter für ein Kraftfahrzeug**

(71) Anmelder: Delphi Technologies, Inc., Troy, Michigan 48007 (US)
(72) Erfinder: Köhler, Joachim, 55546 Biebelsheim (DE); Leng, Peter, 55128 Mainz (DE); Schnell, Klaus, 55435 Gau-Algesheim (DE)
(74) Vertreter: Becker, Bernd

(57) **Zusammenfassung**

Ein Dreh-Zugschalter, insbesondere Lichtschalter, für ein Kraftfahrzeug umfasst eine in einem Gehäuse (1) geführte Achse (5) eines Betätigungselementes (4) und einen Sockel (6). Der Achse (5) sind ein Permanentmagnet (7) und dem Sockel (6) mehrere Magnetfeldsensoren zur Ermittlung der Schaltstellungen des Betätigungselementes (4) zugeordnet.

## Beschreibung

Die Erfindung bezieht sich auf einen Dreh-Zugschalter, insbesondere Lichtschalter, für ein Kraftfahrzeug mit einer in einem Gehäuse geführten Achse eines Betätigungselementes und einem Sockel.

Die DE 199 29 200 A1 offenbart ein Drehwahlschaltersystem, das eine drehbar gelagerte Welle und einen bei einer Bewegung der Welle relativ zu einem magnetoresistiven Sensor verdrehbaren Permanentmagneten umfasst. Die Drehbewegung der Welle wird auf ein drehbar gelagertes Element übertragen, in das der Permanentmagnet eingelassen ist, der drehbar im Wirkbereich des magnetoresistiven Sensors gelagert ist. Die Drehachse der Welle unterscheidet sich von der Drehachse des Permanentmagneten.

Im Weiteren zeigt die DE 199 53 204 A1 ein Schaltmodul zum Schalten von Steuerstrombahnen, insbesondere in Fahrzeugen, mit einem Schaltmodulgehäuse, mit einer insbesondere von einer menschlichen Person betätigbaren Betätigungseinheit und mit einem mit der Betätigungseinheit in Verbindungswirkung stehenden, die Steuerstrombahn schaltenden Schaltglied. Die Betätigungseinheit beaufschlagt einen in dem Schaltmodulgehäuse angeordneten Schaltarm von einer definierten Schaltstellung ohne ein Verbleiben des Schaltarms in einer Zwischenstellung in eine andere definierte Schaltstellung. An dem Schaltarm ist das Schaltglied angeordnet, das die Steuerstrombahn berührungslos schaltet. Die Steuerstrombahn weist einen Magnetfeldsensor, insbesondere ein Hallelement, und das Schaltelement einen in den Detektionsbereich des Magnetfeldsensors führbaren Magneten auf.

Darüber hinaus zeigt die DE 43 19 543 A1 einen Kraftfahrzeug-Lichtschalter mit einem in einem Gehäuse untergebrachten Dreh-Zug-Schalter für das Stand- sowie Fahrtlicht und die Innenbeleuchtung. Dieser Kraftfahrzeug-Lichtschalter weist mehrere mechanische Schaltglieder mit Kontaktelementen zur Beaufschlagung von Anschlusskontakten auf und ist insofern nachteilig, als er in seiner Herstellung verhältnismäßig aufwändig und damit teuer gestaltet ist.

Es ist Aufgabe der Erfindung, einen Dreh-Zugschalter der eingangs genannten Art zu schaffen, der bei einer zuverlässigen Funktionsweise einen verschleißarmen und kostengünstigen Aufbau aufweist.

Erfindungsgemäß wird die Aufgabe dadurch gelöst, dass der Achse ein Permanentmagnet und dem Sockel mehrere drehfest angeordnete Magnetfeldsensoren zur Ermittlung der Schaltstellungen des Betätigungselementes zugeordnet sind.

Aufgrund dieser Maßnahmen wird ein berührungslos die unterschiedlichen Schaltstellungen des Betätigungselementes erfassender Dreh-Zugschalter bereitgestellt, der bei einem kostengünstigen Aufbau einem geringen Verschleiß unterworfen ist. Die Magnetfeldsensoren erfassen sowohl eine Drehrichtungsänderung als auch eine axiale Lageänderung des Permanentmagneten aufgrund einer entsprechenden Beaufschlagung des Betätigungselementes und bewirken entsprechende Schaltvorgänge.

Damit sich der Permanentmagnet direkt im Erfassungsbereich der Magnetfeldsensoren befindet, ist zweckmäßigerweise der Permanentmagnet auf der zu dem Sockel weisenden Stirnseite der Achse angeordnet.

In Ausgestaltung sind die Magnetfeldsensoren als zwei 90° zueinander versetzt angeordnete Hall-Sensoren ausgebildet. Demnach wird bei einer Verdrehung des Permanentmagneten und damit von dessen Magnetfeld von dem einen Pol zu dem anderen Pol ein sinus- bzw. cosinusförmiger Signalverlauf des Stroms erfasst. Durch eine Zug-/Druckbeaufschlagung, also eine axiale Verlagerung des Permanentmagneten, ändert sich die Amplitude des Signalverlaufs. Aufgrund des eindeutig zu bestimmenden Signalverlaufs ist eine Auswertung bezüglich der Position des Betätigungselementes sichergestellt.

Vorzugsweise ist ein Steuergerät über ein Bus-System mit den Hall-Sensoren zur Auswertung der erfassten Signale gekoppelt. Das Steuergerät kann direkt dem Dreh-Zugschalter zugeordnet oder ein bereits in einem Kraftfahrzeug vorhandenes Steuergerät sein und umfasst zumindest einen Rechnerbaustein zur Auswertung der Signale der Hall-Sensoren und zur Steuerung zugeordneter Schaltvorgänge.

Zweckmäßigerweise ist das Bus-System ein LIN-Bus. Das Local Interconnect Network (LIN) wurde speziell für die kostengünstige Kommunikation von intelligenten Sensoren und Aktuatoren in Kraftfahrzeugen entwickelt und kommt überall dort zum Einsatz, wo die Bandbreite und Vielseitigkeit von CAN (Controller Area Network) nicht benötigt wird.

Bevorzugt ist der Sockel in MID-Technik gefertigt und umfasst die Hall-Sensoren. Der in MID-Technik (Moulded Interconnected Devices) hergestellte Sockel kann beispielsweise integrierte Schaltkreise umfassen und weitere elektronische Baugruppen aufweisen.

Alternativ sind die Hall-Sensoren einer Leiterplatte innerhalb des Gehäuses zugeordnet. Die Leiterplatte verbindet weitere elektrische und/oder elektronische Bauteile sowohl miteinander als auch mit einem Bordnetz eines Kraftfahrzeuges.

Um das Betätigungselement in definierten Schaltstellungen zu fixieren, sind zwischen der Achse und dem Gehäuse Rastelemente zur Positionierung der Zug- und Drehschaltstellungen des Betätigungselementes angeordnet. Zweckmäßigerweise ist innerhalb des Gehäuses mindestens ein einer Lichtquelle zugeordneter Lichtleiter zur Hinterleuchtung gehäuseseitiger Symbole angeordnet.

Es versteht sich, dass die vorstehend genannten und nachstehend noch zu erläuternden Merkmale nicht nur in der jeweils angegebenen Kombination, sondern auch in anderen Kombinationen verwendbar sind. Der Rahmen der vorliegenden Erfindung ist nur durch die Ansprüche definiert.

Die Erfindung wird im Folgenden anhand eines Ausführungsbeispieles unter Bezugnahme auf die zugehörigen Zeichnungen näher erläutert. Es zeigt:

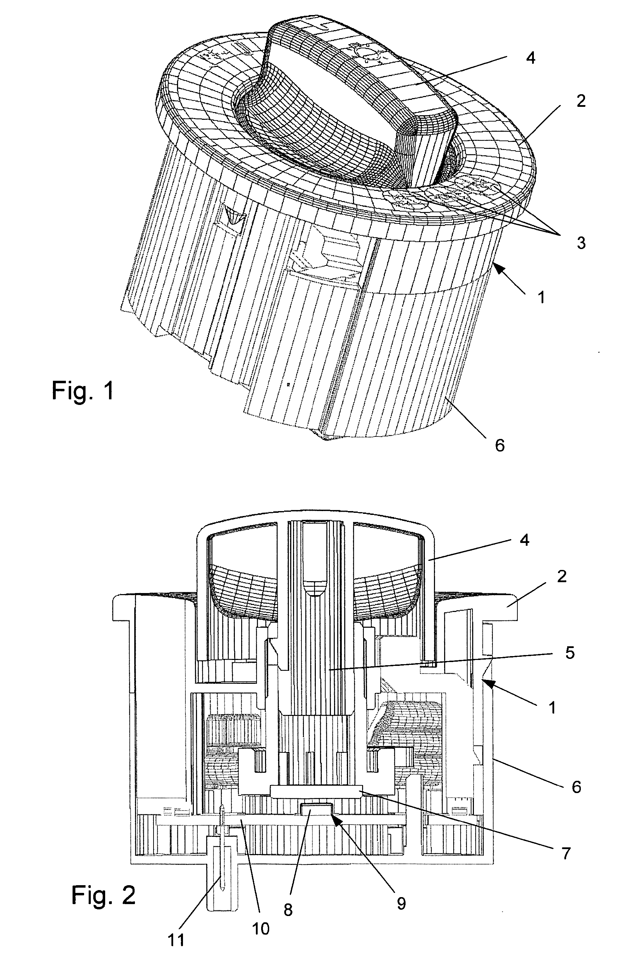

- Fig.1: eine perspektivische Darstellung eines erfindungsgemäßen Dreh-Zugschalters,
- Fig.2: eine Schnittdarstellung des Dreh-Zugschalters nach Fig. 1 und

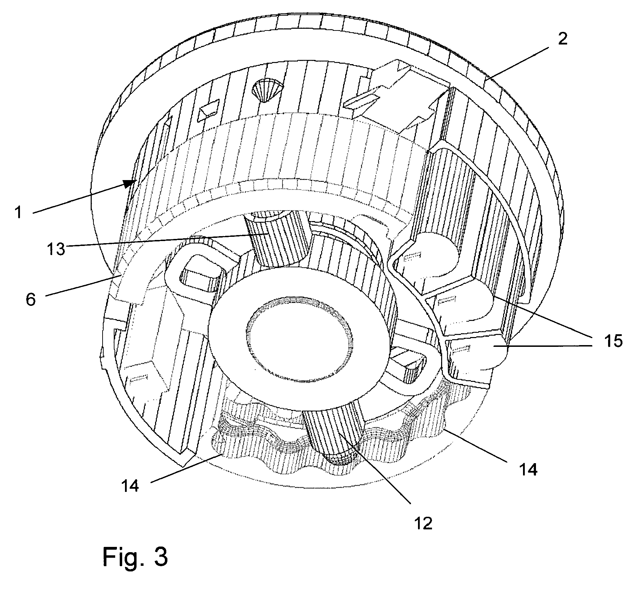

- Fig.3: eine perspektivische Teildarstellung des Dreh-Zugschalters nach Fig. 1.

Der Dreh-Zugschalter umfasst ein Gehäuse 1 mit einer oberseitigen Blende 2, die mehrere hinterleuchtbare Symbole 3 aufweist und durch die ein Betätigungselement 4 ragt, das an seiner Unterseite mit einer in dem Gehäuse 1 verdrehbar sowie axial verschiebbar gelagerten Achse 5 versehen ist. An der freien in Richtung eines Sockels 6 weisenden Stirnseite der Achse 5 ist ein Permanentmagnet 7 angeordnet, der mit zwei zu einer Einheit 8 zusammengefassten Hall-Sensoren 9 zusammenwirkt, die um 90° versetzt zueinander ausgerichtet sind, um die unterschiedlichen Schaltstellungen des durch Drehung und Zug beaufschlagbaren Betätigungselementes 4 zu erfassen. Die Hall-Sensoren 9 sind über in dem Sockel 6 integrierte Leiterbahnen 10 sowie Anschlusskontakte 11 mit einem Bordnetz eines Kraftfahrzeuges gekoppelt. Aufgrund der um 90° versetzten Anordnung der Hall-Sensoren 9 wird bei einer Verdrehung des über die Achse 5 mit dem Permanentmagnet 7 gekoppelten Betätigungselementes 4 ein sinus- bzw. cosinusförmiger Signalverlauf des Stroms erfasst, da das Magnetfeld des Permanentmagneten 7 von dem einen Pol zu dem anderen Pol verdreht wird.

Bei einer Zug-/Druckbeaufschlagung des Betätigungselementes 4 wird der Permanentmagnet 7 auch axial verlagert und die Amplitude des Signalverlaufs entsprechend verändert. Da der Signalverlauf eindeutig zu bestimmen ist, ist eine Auswertung der Position des Betätigungselementes 4 gegeben.

Im Weiteren sind zur Positionierung des Betätigungselementes 4 federnde Rasthülsen 12, 13 an der Achse 5 gelagert, die mit gehäuseseitigen Rasteinbuchtungen 14 zusammenwirken, wobei die eine Rasthülse 12 zur Fixierung in den Drehschaltstellungen und die andere Rasthülse 13 zur Fixierung in den Zugschaltstellungen dient. Darüber hinaus sind in dem Gehäuse 1 Lichtleiter 15 mit zugeordneten Leuchtelementen zur Hinterleuchtung der Symbole 3 aufgenommen, die sich vom Sockel 6 bis zur Blende 2 erstrecken.

## Patentansprüche

1. Dreh-Zugschalter, insbesondere Lichtschalter, für ein Kraftfahrzeug mit einer in einem Gehäuse (1) geführten Achse (5) eines Betätigungselementes (4) und einem Sockel (6), **dadurch gekennzeichnet, dass** der Achse (5) ein Permanentmagnet (7) und dem Sockel (6) mehrere Magnetfeldsensoren zur Ermittlung der Schaltstellungen des Betätigungselementes (4) zugeordnet sind.

2. Dreh-Zugschalter nach Anspruch 1, **dadurch gekennzeichnet, dass** der Permanentmagnet (7) auf der zu dem Sockel (6) weisenden Stirnseite der Achse (5) angeordnet ist.

3. Dreh-Zugschalter nach Anspruch 1, **dadurch gekennzeichnet, dass** die Magnetfeldsensoren als zwei 90° zueinander versetzt angeordnete Hall-Sensoren (9) ausgebildet sind.

4. Dreh-Zugschalter nach Anspruch 3, **dadurch gekennzeichnet, dass** die Hall-Sensoren (9) zur Auswertung der erfassten Signale über ein Bus-System mit einem Steuergerät kommunizieren.

5. Dreh-Zugschalter nach Anspruch 3, **dadurch gekennzeichnet, dass** das Bus-System ein LIN-Bus ist.

6. Dreh-Zugschalter nach einem der Ansprüche 1 bis 5, **dadurch gekennzeichnet, dass** der Sockel (6) in MID-Technik gefertigt ist und die Hall-Sensoren (9) umfasst.

7. Dreh-Zugschalter nach einem der Ansprüche 1 bis 5, **dadurch gekennzeichnet, dass** die Hall-Sensoren (9) einer Leiterplatte innerhalb des Gehäuses (1) zugeordnet sind.

8. Dreh-Zugschalter nach einem der Ansprüche 1 bis 6, **dadurch gekennzeichnet, dass** zwischen der Achse (5) und dem Gehäuse (1) Rastelemente (12, 13) zur Positionierung der Zug- und Drehschaltstellungen des Bbetätigungselementes (4) angeordnet sind.

9. Dreh-Zugschalter nach einem der Ansprüche 1 bis 7, **dadurch gekennzeichnet, dass** innerhalb des Gehäuses (1) mindestens ein einer Lichtquelle zugeordneter Lichtleiter (15) zur Hinterleuchtung gehäuseseitiger Symbole (3) angeordnet ist.

## Geänderte Patentansprüche

### Geänderte Patentansprüche gemäss Regel 86(2) EPÜ.

**1.** Dreh-Zugschalter, insbesondere Lichtschalter, für ein Kraftfahrzeug mit einer in einem Gehäuse (1) geführten Achse (5) eines Betätigungselementes (4) und einem Sockel (6), **dadurch gekennzeichnet, dass** der Achse (5) ein Permanentmagnet (7) und dem Sockel (6) zwei 90° zueinander versetzt angeordnete als Hall-Sensoren (9) ausgebildete Magnetfeldsensoren zur Ermittlung der Schaltstellungen des Betätigungselementes (4) zugeordnet sind, die zur Auswertung der erfassten Signale über ein Bus-System mit einem Steuergerät kommunizieren.

**2.** Dreh-Zugschalter nach Anspruch 1, **dadurch gekennzeichnet, dass** der Permanentmagnet (7) auf der zu dem Sockel (6) weisenden Stirnseite der Achse (5) angeordnet ist.

**3.** Dreh-Zugschalter nach Anspruch 1, **dadurch gekennzeichnet, dass** das Bus-System ein LIN-Bus ist.

**4.** Dreh-Zugschalter nach einem der Ansprüche 1 bis 3, **dadurch gekennzeichnet, dass** der Sockel (6) in MID-Technik gefertigt ist und die Hall-Sensoren (9) umfasst.

**5.** Dreh-Zugschalter nach einem der Ansprüche 1 bis 4, **dadurch gekennzeichnet, dass** die Hall-Sensoren (9) einer Leiterplatte innerhalb des Gehäuses (1) zugeordnet sind.

**6.** Dreh-Zugschalter nach einem der Ansprüche 1 bis 5, **dadurch gekennzeichnet, dass** zwischen der Achse (5) und dem Gehäuse (1) Rastelemente (12, 13) zur Positionierung der Zug- und Drehschaltstellungen des Betätigungselementes (4) angeordnet sind.

**7.** Dreh-Zugschalter nach einem der Ansprüche 1 bis 6, **dadurch gekennzeichnet, dass** innerhalb des Gehäuses (1) mindestens ein einer Lichtquelle zugeordneter Lichtleiter (15) zur Hinterleuchtung gehäuseseitiger Symbole (3) angeordnet ist.
